# EUROPEAN PATENT APPLICATION

(11) **EP 1 394 704 A2**
(43) Date of publication of application: **03.03.2004**
(21) Application number: 03255373.7
(22) Date of filing: 29.08.2003
(51) Int. Cl.: G06F 17/50

(54) **Apparatus and method for simulating switched capacitor circuits**

(30) Priority: 29.08.2002 US 407509 P
(71) Applicant: Anadigm, Inc., Tempe, Arizona 85284 (US)
(72) Inventor: Anderson, Howard C., Tempe, Arizona 85283 (US); Bersch, Danny Austin, Gilbert, Arizona 85234 (US); Macbeth, Ian Craig, Alsager, Cheshire ST7 2PH (GB); Schene, Christopher Robin, Phoenix, Arizona 85032 (US); Streit, Timothy James, Mesa, Arizona 85210 (US)
(74) Representative: Lambert, Ian Robert

(57) **Abstract**

An apparatus is provided for simulating switched-capacitor circuits. The apparatus includes a programmable computing device, a design tool, and a behavioral simulator. The design tool is associated with the programmable computing device and is configured for interaction with a user. The design tool includes a sub-circuit definition for defining a sub-circuit of a programmable circuit device. The behavioral simulator is associated with the design tool. The behavioral simulator is configured to represent each sub-circuit via a set of discrete time-domain equations giving output of the sub-circuit as a function of input to the sub-circuit. A method is also provided.

## Description

### CROSS-REFERENCE TO RELATED APPLICATION

This application claims priority in U.S. Provisional Patent Application Serial No. 60/407,509, entitled "Apparatus and Method for Simulating Switched Capacitor Circuits", which was filed on August 29, 2002, and which is incorporated by reference herein.

### TECHNICAL FIELD

This invention pertains to programmable and configurable devices. More particularly, this invention relates to design and simulation of switched-capacitor circuits.

### BACKGROUND OF THE INVENTION

There are several switched-capacitor simulators in existence. Transistor-level simulators are prohibitively slow when simulating switched-capacitor circuits.

It is possible to consider a switched-capacitor circuit as a discrete time-sampled data system so that the transient behavior of the circuit does not need to be modeled. This type of simulation should be faster than a transistor-level simulation. It is then possible to write faster custom simulations based on difference equations using various software packages, but it is not feasible to write a custom program for each possible circuit in a reconfigurable FPAA.

### SUMMARY OF THE INVENTION

An apparatus and method are provided for enabling the simulation of switched-capacitor circuits that are realizable in a Field-Programmable Analog Array (FPAA). The technique does not require recompilation of an FPAA design system within which a simulation is intended to be run.

According to one aspect, an apparatus is provided for simulating switched-capacitor circuits. The apparatus includes a programmable computing device, a design tool, and a behavioral simulator. The design tool is associated with the programmable computing device and is configured for interaction with a user. The design tool includes a sub-circuit definition for defining a sub-circuit of a programmable circuit device. The behavioral simulator is associated with the design tool. The behavioral simulator is configured to represent each sub-circuit via a set of discrete time-domain equations giving output of the sub-circuit as a function of input to the sub-circuit.

According to another aspect, a method is provided for simulating switched-capacitor circuits realized in a field programmable circuit device. The method includes: providing a programmable computing device, a design tool associated with the programmable computing device, and a behavioral simulator associated with the design tool; embodying computer program code in the programmable computing device including a sub-circuit definition for defining a sub-circuit of a programmable circuit device; and modeling a circuit as a collection of one or more sub-circuits, with each sub-circuit being represented by a set of discrete time-domain equations giving output as a function of input.

According to yet another aspect, a method is provided for simulating switched-capacitorcircuits. The method includes: providing a programmable computing device having a user interface, a design tool associated with the programmable computing device, and a simulator associated with the design tool for representing individual configurable analog modules via a set of discrete time-domain equations giving output of the configurable analog module as a function of input of the configurable analog module; selecting a particular configurable analog module via the user interface; placing the selected configurable analog module on the user interface in association with another configurable analog module; and wiring together the selected configurable analog module with the another configurable analog module via the user interface.

### BRIEF DESCRIPTION OF THE DRAWINGS

Preferred embodiments of the invention are described below with reference to the following accompanying drawings.
Fig. 1 illustrates a block diagram overview of a basic system configuration of an exemplary system for simulating switched-capacitor circuits of a programmable device.
Fig. 2 is a diagram of a screen display for a design tool application window and illustrating a half-cycle gain stage sub-circuit design window.
Fig. 3 is a diagram of a signal generator control dialog box that comprises a pop-up window within the screen display of Fig. 2.
Fig. 4 is a diagram of an oscilloscope dialog box that comprises a pop-up window within the screen display of Fig. 2.

### DETAILED DESCRIPTION OF THE PREFERRED EMBODIMENTS

This disclosure of the invention is submitted in furtherance of the constitutional purposes of the U.S. Patent Laws "to promote the progress of science and useful arts" (Article 1, Section 8).

An apparatus and method was needed to allow simulation of switched-capacitor circuits realizable in a Field-Programmable Analog Array (FPAA). The method needed to be very flexible so that new sub-circuits could be implemented quickly. Addition of a new sub-circuit should not require recompilation of the FPAA Design System within which the simulation would run. Simulation time needed to be minimized.

A method is provided for simulating switched capacitor circuits in which the circuits are modeled as a collection of sub-circuits. This method is compatible with our method for designing circuits with a CAD tool so that the simulation may also be carried out in the same CAD tool used for design. A "behavioral" simulator was devised where each sub-circuit is represented by a set of discrete time-domain equations giving its output as a function of its input(s).

The sub-circuit simulation models are compatible with and used by the CAD tool, but are not an integral part of the CAD tool. The sub-circuit simulation models are part of a sub-circuit definition. This methodology allows simulation support for new sub-circuits to be quickly developed and tested. It eliminates the need to recompile the CAD tool whenever new sub-circuits are created or when old sub-circuits are modified.

The sub-circuit simulation models are in the form of algorithms, which may be realized in interpreter code. These algorithms, when combined with data about the state of the circuit being simulated that is stored in the CAD tool, return information about the state of the sub-circuit such as output voltage.

The simulator includes a means of providing input signals to selected circuit nodes and a means for displaying the output data from selected nodes. The user is able to assign each sub-circuit one or more clock signals. The simulator also simulates clock ticks. The simulator operates by executing individual behavioral sub-circuit models in a particular order. This execution order is determined by the ticking of the clocks and the wiring connecting various sub-circuits. Each sub-circuit model is executed only at a transition of any clock associated with that sub-circuit. Previous execution results are used to determine the state of inputs to the behavioral models. This method models the switched-capacitor circuit as a discrete time sampled system.

What follows is a description of one possible implementation of the invention although other implementations with wider applicability could easily be created.

The simulation models are part of a text file designated as a configurable analog module (CAM) that may be read at any time by the CAD tool, AnadigmDesigner for the AN20 in this implementation. The equations are in the form of C-code text. The simulator resides within AnadigmDesigner. The user is able to use AnadigmDesigner to create complex circuits by selecting and placing CAMs on the computer screen and "wiring" them together. The user is then able to place "signal generators" and "oscilloscope probes" to set up the circuit for simulation. Signal generators behave as sources of inputs. Oscilloscope probes collect and store output data from a particular output node and display the data after completion of the simulation. Each CAM in AnadigmDesigner is represented internally as an "object". Each CAM object obtains its equations in C-code text form from the CAM file and stores them internally where they are available for use during a simulation run.

During a simulation run, the simulator uses the "wirelist", a list of wires that the user placed to connect the CAMS, to determine where the inputs for each CAM originate. The wiring operations available to the user ensure that only valid connections are possible. The simulation equations are executed sequentially in an order determined by the clock associated with each CAM. AnadigmDesigner also contains logic to detect "zero-delay loops" which cannot be simulated correctly and warns the user when such loops exist. The input(s) to a CAM come from either another CAM or from a signal generator according to the wiring placed by the user. The equations are run by submitting them and their appropriate input values and any internally saved values needed by the equations to a C-interpreter. The C-interpreter actually runs fairly quickly and the simulation times are reasonable.

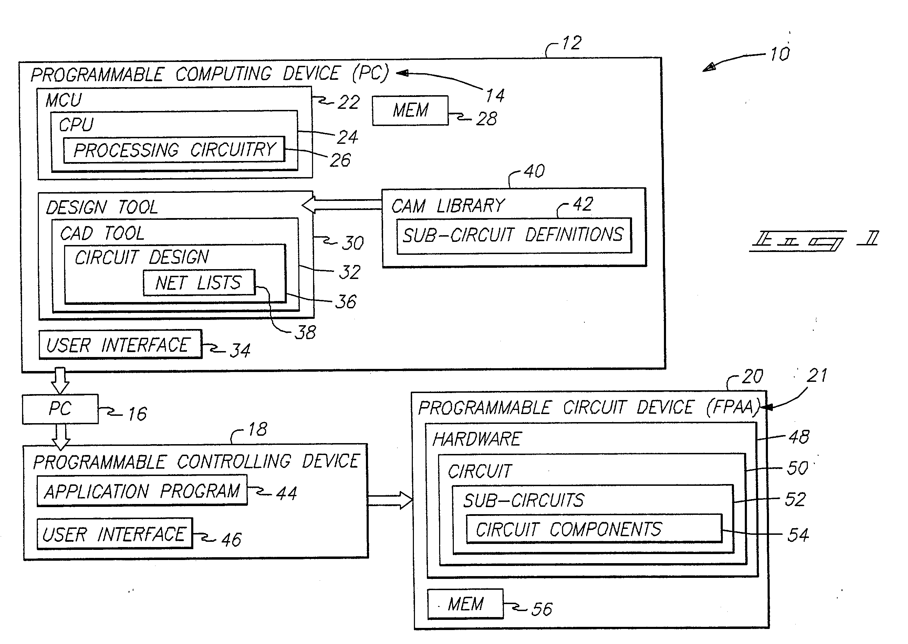

Figure 1 illustrates a preferred embodiment of Applicants' invention wherein a basic system configuration is provided for simulating switched-capacitor circuits, and is identified with reference numeral 10. System 10 includes a programmable computing device 12, such as a personal computer (PC) 14.

As shown in Figure 1, system 10 is implemented in a combination of software and hardware in a manner that enables programming of programmable circuit device 20 using programmable controlling device 18. More particularly, software is provided in the form of exported device information for programming programmable circuit device 20 so that information that is required for close coupled control is made available for use in developing a controller program via a central processing unit (CPU) program. Programmable controlling device 18 then makes modified configuration data available to programmable circuit device 20 either by (a) modifying all or part of the configuration data, and then applying the configuration data to the registers within the programmable circuit device 20, or (b) directly modifying all or part of the configuration data contained within the registers of the programmable circuit device 20. Using configuration data, programmable circuit device 20 is programmed as a consequence of the software. Software aspects of the system generate, in addition to usual configuration data of prior art systems, code which may be used by a second configurable device in order to modify, in whole or in part, functionality of programmable circuit device 20.

As shown in Figure 1, programmable computing device 12 in one form comprises a personal computer (PC) 14. PC 14 includes a micro-controller unit (MCU) 22, memory 28, a design tool 30, a user interface 34, and a configurable analog module (CAM) library 40. MCU 22 includes a central processing unit (CPU) 24 that includes processing circuitry 26. Design tool 30 includes a computer-aided design (CAD) tool 32 in which one or more circuit designs 36 are generated and modeled. Each circuit design 36 includes circuit model information in the form of netlists 38.

CAM library 40 includes a plurality of sub-circuit definitions 42 that contain information about respective sub-circuits, such as switched-capacitor circuits. In one case, a sub-circuit definition is a configurable analog module (CAM). Accordingly, CAM library 40 comprises a plurality of CAMS. Programmable controlling device 18 includes an application program 44 and a user interface 46. In operation, application program 44 includes computer program code for implementing software monitoring and control functions within the associated application system. User interface 46 enables such monitoring and control functionality.

Programmable circuit device 20, in one form, comprises a field programmable analog array (FPAA) 21. FPAA 21 includes hardware 48 and memory 56. Hardware 48 is configurable via programming into multiple unique configurations. More particularly, a circuit 50 is realized within FPAA 21 by wiring or connecting together sub-circuits (such as switched-capacitor circuits) 52 and circuit components 54 into a desired configuration.

Design tool 30 comprises AnadigmDesigner2. An earlier version, AnadigmDesigner, has previously been publicly available for download and use at http://www.anadigm.com from Anadigm Ltd., United Kingdom, and is herein incorporated by reference.

According to such techniques, the simulation of circuits and the generation of programming data is greatly simplified using computer-aided design (CAD) tools. CAD tools represent the design in a manner that is familiar to a circuit designer, and which automatically generates corresponding data needed to program an FPAA. The ability to modify or generate such programming in the absence of such computer-aided design tools is limited, and almost prohibitive.

In operation, an initial set of configuration data is generated by design tool 30. Configuration data is provided via exported device information to a compiler (not shown) within PC 16. Additionally, or optionally, configuration data is provided via a user program (not shown) of PC 16 to the compiler. Further details of methods for configuring a programmable semiconductor device are disclosed in U.S. Patent No. 6,272,669 B1, entitled "Method for Configuring a Programmable Semiconductor Device", herein incorporated by reference. Additional details of an apparatus and method for configuring analog elements in a configurable hardware device are disclosed in U.S. Patent Application Serial No. 10/171,334, entitled "System and Method for Configuring Analog Elements in a Configurable Hardware Device", herein incorporated by reference.

The specific improvements added over those presently available in publicly usable and commercially available AnadigmDesigner include the ability to simulate switched-capacitor circuits and to design a circuit by assembling together a group of sub-circuit designs in a CAD tool. Once designed, the circuit (or sub-circuit) design can be realized in a programmable device, such as a field programmable analog array (FPAA). The CAD tool provides a mechanism for translating the circuit design into properly formatted data needed to program the device. Sub-circuit definitions for respective sub-circuits are compatible with the CAD tool, but are not an integral part of the CAD tool. The sub-circuit definitions are portable individually orin groups. More particularly, the sub-circuit definitions do not need to be compiled in order to use them with the CAD tool. Hence, the sub-circuit definitions can easily be created or modified to change functionality of the associated sub-circuit while still maintaining compatibility with the CAD tool.

The sub-circuit definitions contain information about the sub-circuit needed to do several things. First, they contain information about the sub-circuit needed to define multiple configurations, topologies, and parameters of the sub-circuit. Secondly, the sub-circuit definitions contain information about the sub-circuit needed to define and control the user interface that allows control of these multiple configurations. Thirdly, they contain information about the sub-circuit needed to modify the configuration of the sub-circuit based on user selections. Fourth, they contain information about the sub-circuit needed to provide error checking regarding the correct use of the sub-circuit. Fifth, they contain information about the sub-circuit needed to simulate the sub-circuit behavior within a larger analog circuit. Sixth, they contain information about the sub-circuit needed to draw a symbolic representation of the sub-circuit. Seventh, they contain information about the sub-circuit needed to determine the version number of the sub-circuit. Eighth, they contain information about the sub-circuit needed to determine the sub-circuit's compatibility with a particular CAD tool or version of a particular CAD tool. Ninth, they contain information about the sub-circuit needed to determine the sub-circuit's compatibility with a programmable device, such as an FPAA.

Some of the information about the sub-circuit is contained in the form of algorithms which may be realized in interpreter code. When the information in the algorithms is combined with data stored in the CAD tool and data taken from user interfaces run by the CAD tool, the algorithms return the desired information to the CAD tool. For example, information about modifying the configurations of the sub-circuit in response to user selections (item three, above) is handled in this manner.

CAD tool 32 (of Fig. 1) has the ability to do several things. First, it can read data contained in the sub-circuit definitions. Secondly, it can provide a user interface wherein the user can assemble the sub-circuits into larger circuits. Thirdly, it can provide a user interface for each sub-circuit so that a user can change the configuration and behavior of that sub-circuit design. Fourth, it can run interpreter code contained in the sub-circuit definitions. Fifth, it can provide a user interface with functionality that is specific to a particular programmable device. Sixth, it can set up and run a simulation using the circuit design and information contained in the sub-circuit definitions. Seventh, it can view the results of a simulation. Eighth, it can transform the circuit design into properly formatted data to download to a programmable device. Ninth, it can facilitate download of the properly formatted data to a programmable device.

The above-referenced features allow significant design expertise to be contained within the sub-circuit definitions, including sub-circuit topology, the relationship of sub-circuit topology and component values to higher level parameters displayed by the user interface, and sub-circuit performance as shown through simulation. The sub-circuit definitions, together with the CAD tool, contain specific details of the programmable device architecture. Accordingly, it is not required that a person utilizing this technique be an expert in circuit design or the programmable device. Instead, the user can work in a higher level of abstraction represented by the user interfaces of the sub-circuits and CAD tool. Hence, the design of circuits and the translation of circuits to a properformat for programming an FPAA chip is both relatively quick and easy.

Sub-circuit definitions, in the form of a configurable analog module (CAM), comprise a fully self-contained definition of one or more sub-circuits (or circuits, such as switched-capacitor circuits) which can be configured in a programmable device, such as an FPAA chip. A sub-circuit definition includes "C" code that forms an integrated part of the sub-circuit definition, and interacts intimately with other sub-circuits. A CAM includes "snippets", or relatively small segments, of "C" code which define configuration, as well as a simulation model.

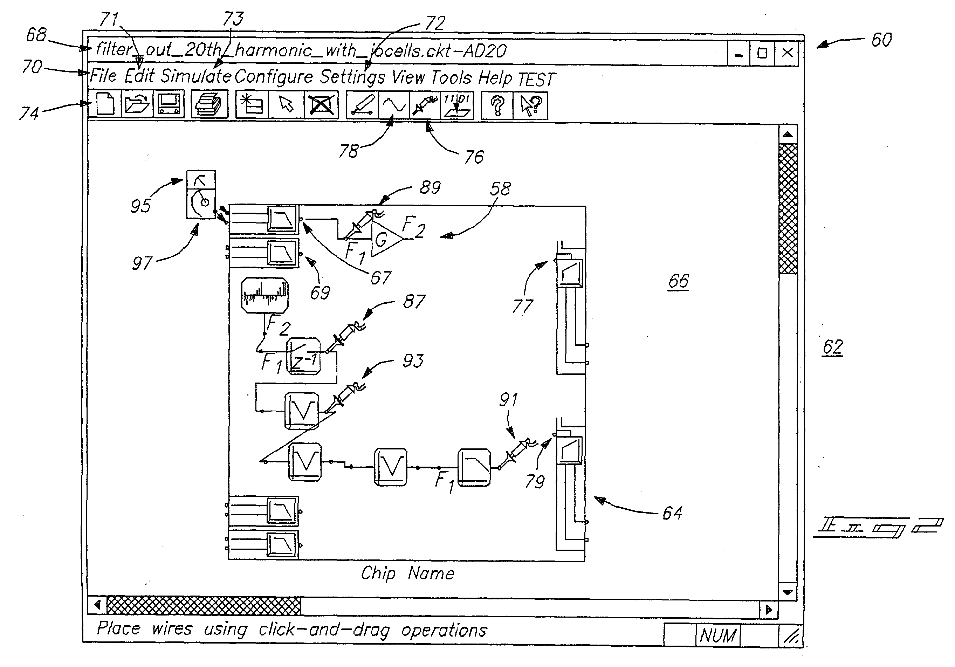

Figures 2-4 illustrate one possible implementation of the present invention. However, it is understood that other implementations having wider applicability are also possible and fall within the scope of the appended claims.

Figure 2 illustrates set-up of specific analog circuitry (or sub-circuitry) that will realize a half-cycle gain stage 58 within AnadigmDesigner2, a new version of AnadigmDesigner. By starting the application of AnadigmDesigner2 (a CAD tool), a user is presented with the screen display 60 depicted in Figure 2 within a design tool application window 62. An AN220E04 FPAA chip design 64 is provided within work space 66 to enable construction of a specific chip design.

Screen display 60 includes a header 68, a menu bar 70 in which a plurality of menu items 71-73 are displayed for selection by a user, and a tool bar 74 in which a plurality of selectable tool bar buttons 76 and 78 are provided.

With the exception of specific menu items for "Edit", "Simulate", "Configure", and "Settings" depicted in Figure 2 and the simulation of switched-capacitor circuits, the remaining menu items of menu bar 70 are presently available in AnadigmDesigner, an earlier version of AnadigmDesigner2. Accordingly, the functional details of such other menu items are not discussed herein in great detail in order to prevent obscuring the invention at hand. Instead, the added functionality and details provided by the "Edit" and "Simulate" menu items 71 and 73 will be discussed in greater detail below.

Chip design 64 provides an initial template in which a specific chip design is generated using AnadigmDesigner2. More particularly, chip design 64 includes a plurality of input cells, such as input cells 67 and 69, as well as a plurality of output cells, such as output cells 77 and 79.

According to the present implementation, a sub-circuit definition comprises a configurable analog module (CAM) present within a CAM library of the CAD tool. According to one implementation, a CAM is a single text file containing all the information needed to define a particular sub-circuit corresponding to the sub-circuit description. The half-cycle gain stage 58 of Figure 2 provides one example of a CAM.

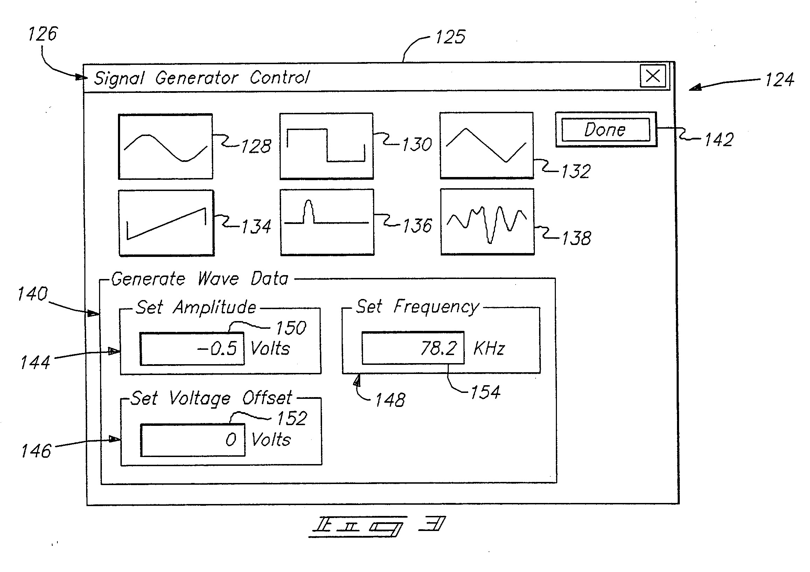

As shown in Figure 2, a pair of signal generators 95 and 97 have been applied to input leads on input cell 67. Each signal generator 95 and 97 is generated by selecting tool bar button 78 which launches the icon for signal generators 95 and 97 which is then placed via a mouse and cursor at the desired input pin. By right clicking to select the icon for signal generators 95 or 97, a menu item is generated. The selected menu item is then displayed, entitled "Signal Generator Settings". Selection of such menu item launches screen display 124 of Figure 3; namely, a signal generator control dialog box 125 (of Fig. 3).

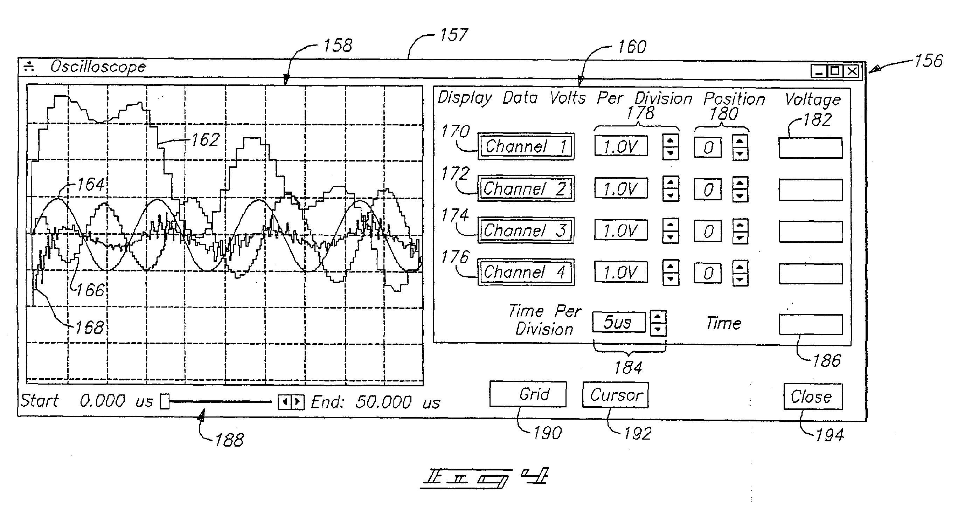

Additionally, a plurality of oscilloscope probes 87, 89, 91, and 93 are applied at selected locations within the sub-circuit design by selecting tool bar button 76 which generates a movable oscilloscope icon that can be positioned and placed via a computer mouse and cursor by left clicking on the mouse once the cursor has been placed at the appropriate node. Once placed, a user can right click on the oscilloscope probe icon 87, 89, 91, or 93 which launches a menu including a "Oscilloscope" menu item. Selection of the menu via a mouse and cursor launches the oscilloscope dialog box 157 of Figure 4.

Screen display 60 enables a user to render user-selected options that are used with interpreter code to determine the proper configuration of the corresponding "half-cycle gain stage" sub-circuit. The configuration is specified by one of the netlists contained in the corresponding CAM. Each netlist includes references to capacitors, operational amplifiers (op amps), and other analog components that exist on the FPAA, or chip. The netlists also contain connectivity information that shows how these components need to be connected in order to realize the user-selected configuration of the "half-cycle gain stage".

Figure 3 illustrates a screen display 124 for a "Signal Generator Control" dialog box 125. Dialog box 125 includes a "Signal Generator Control" header 126, waveform buttons 128, 130, 132, 134, 136, and 138, "Generate Wave Data" field 140, and "Done" button 142. Buttons 128, 130, 132, 134, 136, and 138 are alternately selected in order to configure a desired signal generator to generate a corresponding signal at the designated pin or cell where a signal generator 95 or 97 (of Fig. 2) has been placed via selection of signal generator button 78 (of Fig. 2).

For example, selection of waveform button 128 configures the signal generator to apply a sine wave at a selected pin. Selection of waveform button 130 configures the signal generator to apply a square wave. Selection of waveform button 132 configures the signal generator to apply a triangle wave. Selection of waveform button 134 configures the signal generator to apply a sawtooth wave. Selection of waveform button 136 configures the signal generator to apply a Dirac impulse. Finally, selection of waveform button 138 configures the signal generator to apply an arbitrary wave.

"Generate Wave Data" field 140 includes a "Set Amplitude" field 144, a "Set Voltage Offset" field 146, and a "Set Frequency" field 148. "Set Amplitude" field 144 includes a "Volts" entry field 150 for entering a voltage amplitude for the selected signal for the signal generator. "Set Voltage Offset" field 146 includes a "Volts" entry field 152 which enables a user to set a voltage offset for the selected signal for the signal generator. "Set Frequency" field 148 includes a "Volts" entry field 154 which enables a user to set a frequency for the selected signal for the signal generator.

Figure 4 illustrates a screen display 156 for an "Oscilloscope" dialog box 157. Selection of "Oscilloscope" button 78 (of Fig. 2) generates a movable oscilloscope icon that can be positioned and placed via a mouse cursor at a specific location within the chip design 64 (of Fig. 2). By clicking on the mouse cursor once the icon has been placed at an appropriate node, a user can then right click on the oscilloscope probe icon 87 (see Fig. 2), which launches a menu that includes an "Oscilloscope" menu item. Selection of the "Oscilloscope" menu item via using a mouse cursor launches the oscilloscope dialog box 157 of Figure 4.

Accordingly, "oscilloscope" dialog box 157 includes a signal output display field 158 in which a time-domain output 162, 164, 166, and 168 is displayed for channels 1-4, corresponding with channels identified by "Channel Selection" boxes 170, 172, 174, and 176. By way of example, oscilloscope output waveform 162 corresponds with an oscilloscope output identified by oscilloscope probe icon 87 (of Fig. 2), corresponding with "channel 1 ". Similarly, an output for "channel 2" consists of output 164 which corresponds with oscilloscope probe 89 (of Fig. 2). Output 166 is for "channel 3", corresponding with oscilloscope probe icon 91 (of Fig. 2). Finally, output 168 corresponds with "channel 4", from oscilloscope probe icon 93 (of Fig. 2).

"Oscilloscope" dialog box 157 includes a "display data" field 160 in which channel selection boxes 170,172,174, and 176 are provided. A "volts per divisions" scrolling list box 178 is provided for each channel, corresponding with a voltage scale for the ordinate, or y-axis. A second scrolling list box 180 is provided for channels 1-4 for "position" scrolling list box 180. Each channel 1-4 also includes a "Voltage" data entry field 182 in which a specific voltage value is displayed for each channel at a corresponding period in time along the abscissa, orx-axis, within display field 158. Furthermore, the "time per division" scrolling entry field 184 enables a user to adjust the time per division within signal output display field 158. Furthermore, a "time" entry field 186 displays a time corresponding with a selected time indicated by location of a cursor line within display field 158 and corresponding with voltages displayed within individual data entry fields 182.

A scrolling time-line bar 188 enables a user to select a specific position along an abscissa time-line within display field 158 which then displays corresponding voltages within the entry fields 182 for channels 1-4, as well as a time within time entry field 186. Accordingly, scrolling time-line bar 188 corresponds with the abscissa, or time domain, of data field 158.

A "Grid" button 190 enables a user to turn grid lines on and off, as shown in the signal output display field 158 (of Fig. 4). A "Cursor" button 192 puts a cursor upon screen display 156 that a user can move using a mouse. "Voltage" data entry fields 182 and "Time" entry field 186 display values that correspond with data at the cursor position. A "Close" button 194 enables a user to close screen display 156.

Although the above invention has been described by way of example as a specific implementation of switched-capacitor circuits, the apparatus and method can equally well be used for any sampled-data system. For example, the apparatus and method can also be applied to switched-current circuits, digital signal processing, pulse-based systems, or any other sampled-data system.

In compliance with the statute, the invention has been described in language more or less specific as to structural and methodical features. It is to be understood, however, that the invention is not limited to the specific features shown and described, since the means herein disclosed comprise preferred forms of putting the invention into effect. The invention is, therefore, claimed in any of its forms or modifications within the properscope of the appended claims appropriately interpreted in accordance with the doctrine of equivalents.

## Claims

1. An apparatus for simulating switched capacitor circuits, comprising:
a programmable computing device;
a design tool associated with the programmable computing device and configured for interaction with a user, the design tool comprising computer program code embodied in the programmable computing device including a sub-circuit definition for defining a sub-circuit of a programmable circuit device; and
a behavioral simulator associated with the design tool and configured to represent each sub-circuit via a set of discrete time-domain equations giving output of the sub-circuit as a function of input to the sub-circuit.

2. The apparatus of claim 1 further comprising a user interface associated with the programmable computing device and configured to enable a user at the user interface to interact with the design tool.

3. The apparatus of claim 2 wherein the set of discrete time-domain equations is provided by a sub-circuit simulation model for the sub-circuit.

4. The apparatus of claim 3 wherein each sub-circuit simulation model is compatible with the design tool and is used by the design tool, but is not an integral part of the design tool.

5. The apparatus of claim 3 wherein the sub-circuit simulation model is part of a sub-circuit definition.

6. The apparatus of claim 5 wherein the sub-circuit definition provides the sub-circuit simulation model in a manner that eliminates the need to recompile the design tool when new sub-circuits are created, or when existing sub-circuits are modified by a user of the design tool.

7. The apparatus of claim 3 wherein a sub-circuit simulation model comprises one or more algorithms.

8. The apparatus of claim 7 wherein the one or more algorithms are each realized at least in part in interpreter code.

9. The apparatus of claim 8 wherein the design tool is configured to store data about a state of a circuit being simulated.

10. The apparatus of claim 9 wherein the behavioral simulator is configured to combine the algorithms with the data about the state of the circuit being simulated and return information about a state of the sub-circuit.

11. The apparatus of claim 10 wherein the behavioral simulator returns information about output voltage for the sub-circuit.

12. The apparatus of claim 1 wherein the design tool is configured to define a sub-circuit of a field programmable analog array.

13. The apparatus of claim 12 wherein the sub-circuit comprises switched-capacitor circuits realizable in a field programmable analog array.

14. The apparatus of claim 1 wherein the behavioral simulator is configured to provide input signals to selected circuit nodes of the sub-circuit.

15. The apparatus of claim 1 wherein the behavioral simulator is configured to display output data from selected circuit nodes of the sub-circuit.

16. The apparatus of claim 1 wherein the design tool enables a user to assign each of a plurality of sub-circuits with one or more clock signals.

17. The apparatus of claim 16 wherein the behavioral simulator is configured to simulate clock ticks and is operative to execute individual behavioral sub-circuit models in a particular order as determined at least in part by the clock ticks and a wiring layout connecting together the sub-circuits.

18. The apparatus of claim 3 wherein the sub-circuit simulation model is provided by a configurable analog module in the form of a text file that is capable of being read by the design tool.

19. The apparatus of claim 18 wherein the configurable analog module is selected and placed in memory of the programmable computing device at a detectable location relative to other sub-circuits, and the sub-circuits are then wired together.

20. A method for simulating switched-capacitor circuits realized in a field programmable circuit device, comprising:
providing a programmable computing device, a design tool associated with the programmable computing device, and a behavioral simulator associated with the design tool;
embodying computer program code in the programmable computing device including a sub-circuit definition for defining a sub-circuit of a programmable circuit device; and
modeling a circuit as a collection of one or more sub-circuits, with each sub-circuit being represented by a set of discrete time-domain equations giving output as a function of input.

21. The method of claim 20 further comprising providing a user interface associated with the programmable computing device, and visually rendering a modeled circuit on the user interface.

22. The method of claim 21 further comprising visually rendering a plurality of sub-circuits on the user interface, and further comprising wiring together at least two of the sub-circuits.

23. The method of claim 22 further comprising placing at least one signal generator on the user interface in association with the wired-together sub-circuits.

24. The method of claim 22 further comprising placing at least one oscilloscope probe via the user interface in association with the wired-together sub-circuits.

25. The method of claim 20 wherein a sub-circuit is provided by a configurable analog module in the form of a text file that is capable of being read by the design tool.

26. A method for simulating switched-capacitor circuits, comprising:
providing a programmable computing device having a user interface, a design tool associated with the programmable computing device, and a simulator associated with the design tool for representing individual configurable analog modules via a set of discrete time-domain equations giving output of the configurable analog module as a function of input of the configurable analog module;
selecting a particular configurable analog module via the user interface;
placing the selected configurable analog module on the user interface in association with another configurable analog module; and
wiring together the selected configurable analog module with the another configurable analog module via the user interface.

27. The method of claim 26 wherein the simulator uses a wirelist comprising a list of wires placed by a user in order to connect together the one configurable analog module with another configurable analog module.

28. The method of claim 26 wherein each of the sets of discrete time-domain equations provides simulation equations, and further comprising executing the simulation equations sequentially in an order determined bya clock associated with each configurable analog module.

29. The method of claim 28 further comprising detecting zero-delay loops within a circuit of the sub-circuits which is incapable of being simulated correctly, and warning a user upon detection of a zero-delay loop.
